# EUROPEAN PATENT APPLICATION

(11) **EP 4 583 162 A1**
(43) Date of publication of application: **09.07.2025**
(21) Application number: 23859915.3
(22) Date of filing: 26.07.2023
(51) Int. Cl.: H01L 25/07, B22F 1/10, B22F 7/08, H01L 25/18

(54) **TEMPORARY FIXATION COMPOSITION, BONDED STRUCTURE MANUFACTURING METHOD, AND USE OF TEMPORARY FIXATION COMPOSITION**

(30) Priority: 31.08.2022 JP 2022138645
(71) Applicant: Mitsui Mining & Smelting Co., Ltd., Shinagawa-ku Tokyo 141-8584 (JP)
(72) Inventor: ANAI, Kei, Ageo-shi, Saitama 362-0021 (JP); NISHIKAWA, Jo, Ageo-shi, Saitama 362-0021 (JP); MATSUYAMA, Toshikazu, Ageo-shi, Saitama 362-0021 (JP)
(74) Representative: Novagraaf Technologies
(86) International application number: PCT/JP2023/027334
(87) International publication number: WO 2024/048146

(57) **Abstract**

A temporary fixing composition of the present invention contains an organic component in a proportion of 42 mass% or more and 95 mass% or less. The organic component is solid at 25°C and has a 95% mass loss temperature in nitrogen of 300°C or lower. The temporary fixing composition is used to temporarily fix a first bonding target material and a second bonding target material to each other before the two bonding target materials are bonded to each other. A method for producing a bonded structure of the present invention includes temporarily fixing a first bonding target material and a second bonding target material to each other with the temporary fixing composition disposed therebetween and firing the temporarily fixed two bonding target materials to bond the two bonding target materials to each other.

## Description

### Technical Field

The present invention relates to a composition used to temporarily fix two bonding target materials to each other before the two materials are bonded to each other, and use of the composition. The present invention also relates to a method for producing a bonded structure using the composition.

### Background Art

In recent years, semiconductor devices called power devices have become increasingly widely used as power conversion/control devices such as inverters. Unlike integrated circuits such as memories and microprocessors, power devices are used to control high current, and therefore generate a very large amount of heat when operating. Accordingly, it is necessary to use materials that have better heat dissipation properties, and for power devices, various techniques have been proposed in which a paste containing metal microparticles with limited use of harmful chemical substances is used instead of conventional solder, and the paste is applied to a target object using any of various coating means and then fired.

For example, Patent Literature 1 discloses a method in which a paste containing silver particles is disposed between a semiconductor chip and a chip mounting part, and the semiconductor chip is bonded to the chip mounting part via a sintered body of the silver particles. In this method, a temporary fixing agent having tackiness is supplied such that it has a portion that is in contact with the chip mounting part, and the semiconductor chip is mounted on the paste such that a portion of an under surface of the semiconductor chip comes into contact with the temporary fixing agent.

### Citation List

### Patent Literature

Patent Literature 1: US 2018/247884A1

### Summary of Invention

However, the temporary fixing agent disclosed in Patent Literature 1 is in liquid form and may not solidify, or may take a long time to solidify, after being applied, resulting in a prolonged process time during chip mounting. In this case, the temporary fixing agent permeates a dried film made of the paste, which serves as a bonding body, over time, causing the problem of insufficient tackiness.

Therefore, it is an object of the present invention to provide a temporary fixing composition that quickly solidifies after application, a method for producing a bonded structure using the composition, and a method of use of the composition.

The present invention provides a temporary fixing composition comprising:
a first organic component in a proportion of 42 mass% or more and 95 mass% or less, the first organic component being solid at 25°C and having a 95% mass loss temperature in nitrogen of 300°C or lower,
wherein the temporary fixing composition is used to temporarily fix a first bonding target material and a second bonding target material to each other before the first bonding target material and the second bonding target material are bonded to each other.

Also, the present invention provides a method for producing a bonded structure, comprising:
temporarily fixing a first bonding target material and a second bonding target material to each other with a temporary fixing composition disposed between the first bonding target material and the second bonding target material; and
firing the first bonding target material and the second bonding target material which are temporarily fixed to bond the first bonding target material and the second bonding target material to each other,
wherein, the temporary fixing composition comprises a first organic component in a proportion of 42 mass% or more and 95 mass% or less, the first organic component being solid at 25°C and having a 95% mass loss temperature in nitrogen of 300°C or lower.

Furthermore, the present invention provides use of a composition for temporarily fixing a first bonding target material and a second bonding target material to each other before the first bonding target material and the second bonding target material are bonded to each other,
the composition comprising:
a first organic component in a proportion of 42 mass% or more and 95 mass% or less, the first organic component being solid at 25°C and having a 95% mass loss temperature in nitrogen of 300°C or lower.

### Brief Description of Drawings

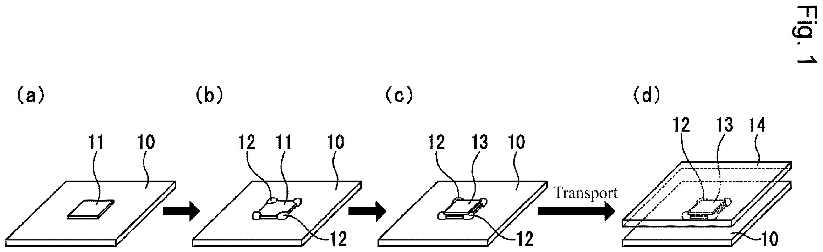

[Fig. 1] Figs. 1(a) to 1(d) are schematic diagrams sequentially illustrating a process of bonding two bonding target materials to each other using a temporary fixing composition of the present invention.

### Description of Embodiments

The present invention relates to a temporary fixing composition. The temporary fixing composition is used to temporarily fix a first bonding target material and a second bonding target material to each other before the two bonding target materials are bonded (i.e., permanently fixed) to each other. The first bonding target material and second bonding target material which are temporarily fixed are bonded to each other in the next step, for example, a firing step, to thereby form a bonded structure.

"Temporary fixing" means a mode in which the first bonding target material and the second bonding target material are fixed to each other and, even though the fixed state will change if a large external force is applied, the fixed state will not be changed by a small external force (e.g., a force of such magnitude that, when a temporarily fixed product of the first bonding target material and the second bonding target material is placed with surfaces to be bonded of the two bonding target materials extending in the vertical direction, either the first bonding target material or the second bonding target material will fall off under its own weight).

There is no particular limitation on the types of the first bonding target material and the second bonding target material. In general, it is preferable that both of the first and second bonding target materials contain a metal in their surfaces to be bonded to each other. For example, a member that has a surface made of a metal can be used as at least one of the first bonding target material and the second bonding target material.

Also, a structure containing metal microparticles can be used as at least one of the first bonding target material and the second bonding target material. This structure may be a dried product of a paste or a sheet that contains, for example, metal microparticles and at least either a resin or an organic solvent. Specifically, it is possible to use a member that has a surface made of a metal as the first bonding target material and use the above-described structure as the second bonding target material. When a dried product of a paste is used as the above-described structure, it is preferable to obtain the dried product by coating the paste onto a support base material made of a metal, such as copper, and drying the paste. When a sheet is used as the above-described structure, the sheet may be pressure-bonded to a support base material made of a metal, such as copper, or may be used without being pressure-bonded. Note that when the sheet is used without being pressure-bonded, it is preferable to use the temporary fixing composition between the sheet and the support base material made of a metal, such as copper.

Note that, if the above-described "structure" is heated in the next step, for example, the metal microparticles contained in the structure are sintered together, and for this reason, the structure can be regarded as a sintering precursor. Therefore, in the present specification, the "structure" will hereinafter also be referred to as a "sintering precursor".

In the case where the first bonding target material is constituted by a member that has a surface made of a metal and the second bonding target material is constituted by a sintering precursor, the metal of the first bonding target material and the metal of the metal microparticles of the second bonding target material may be of the same type or of different types. Here, the term "metal" refers to a metal itself that is not combined with another element to form a compound, or to an alloy made of two or more metals. There is no particular limitation on the type of metal, but considering that the temporary fixing composition of the present invention is to be used in combination with a bonding member that is substituted for solder, it is advantageous to use a metal that has a higher melting point than the melting point of solder. Examples of such metal include copper, silver, gold, aluminum, titanium, nickel, and an alloy composed of a combination of two or more thereof.

In the case where at least one of the first bonding target material and the second bonding target material is a member that has a surface made of a metal, the surface made of a metal may be composed of one metal or two or more metals. In the case where the surface made of a metal is composed of two or more metals, this surface may be made of an alloy. In general, it is preferable that the surface made of a metal is planar, but the surface made of a metal may be curved in some cases.

The metal microparticles contained in the structure may be composed of one metal or an alloy of two or more metals. The metal microparticles may also be composed of a mixture of two or more of metal microparticles of different metal types.

From the viewpoint of keeping the first bonding target material and the second bonding target material in a well bonded state, it is preferable that the volume-based cumulative particle size D_{SEM50} of the metal microparticles is 0.01 µm or more and 30 µm or less. From the same viewpoint, D_{SEM50} is more preferably 0.03 µm or more and 20 µm or less, and even more preferably 0.05 µm or more and 15 µm or less.

The volume-based cumulative particle size D_{SEM50} can be determined using, for example, the following measurement method. Metal microparticles with well-defined contours are imaged using a scanning electron microscope (SEM) within a magnification range of 10,000x or more and 150,000x or less. With the use of Mac-View, manufactured by Mountech Co., Ltd., the SEM image of the metal microparticles is loaded, then, fifty or more metal microparticles in the SEM image are randomly chosen, and the particle size (Heywood diameter) of each particle is measured. Then, from the obtained Heywood diameters, the volumes of the particles are calculated assuming that the particles have a perfect spherical shape, and the particle size at a cumulative volume of 50 vol% of the calculated volumes is used as the volume-based cumulative particle size D_{SEM50}.

The shape of the metal microparticles is not particularly limited, and may be, for example, a spherical shape, a polyhedral shape, a flat shape, an irregular shape, or a combination of these. Moreover, the metal microparticles may have two or more peaks in a particle size distribution thereof.

A surface treatment agent may be attached to the surfaces of the metal microparticles. When the surface treatment agent is attached to the surfaces of the metal microparticles in advance, excessive aggregation of the metal microparticles can be suppressed.

There is no particular limitation on the surface treatment agent, and examples of the surface treatment agent include a fatty acid, an aliphatic amine, a silane coupling agent, a titanate-based coupling agent, an aluminate-based coupling agent, or the like. When such a surface treatment agent is used, the surface treatment agent interacts with the surfaces of the particles, thereby improving the compatibility of the particles with the organic solvent contained in the paste or the resin in the sheet. This can enhance the fluidity of the paste and prevent oxidation of the particle surfaces.

Specific examples of the fatty acid or the aliphatic amine include benzoic acid, pentanoic acid, hexanoic acid, octanoic acid, nonanoic acid, decanoic acid, lauric acid, palmitic acid, oleic acid, stearic acid, pentylamine, hexylamine, octylamine, decylamine, laurylamine, oleylamine, stearylamine, and the like. As the fatty acid or the aliphatic amine, one of those listed above may be used alone, or two or more thereof may be used in combination.

The paste and the sintering precursor, which is a dried product of the paste, may contain an adjusting agent for adjusting various properties of the paste or the sintering precursor. Examples of the adjusting agent include a reducing agent, a viscosity modifier, and a surface tension modifier.

As the reducing agent, those that promote sintering of copper particles are preferable, and examples of the reducing agent include monohydric alcohols, polyhydric alcohols, amino alcohols, citric acid, oxalic acid, formic acid, ascorbic acid, aldehyde, hydrazine and its derivatives, hydroxylamine and its derivatives, dithiothreitol, phosphite, hydrophosphite, phosphorous acid and its derivatives, and the like.

The viscosity modifier may be any viscosity modifier that can adjust the level of viscosity of the paste, and examples thereof include ketones, esters, alcohols, glycols, hydrocarbons, polymers, and the like.

The surface tension modifier may be any surface tension modifier that can adjust the surface tension of the paste, and examples thereof include polymers, such as acrylic surfactants, silicone-based surfactants, alkylpolyoxyethylene ethers, and fatty acid glycerol esters, and monomers, such as alcohol-based monomers, hydrocarbon-based monomers, ester-based monomers, and glycols.

When obtaining a dried product from the paste, it is not necessary to remove all of the organic solvent; it is sufficient to remove enough organic solvent for a coating film of the paste to lose fluidity. Accordingly, the organic solvent may remain in the sintering precursor. The proportion of the organic solvent contained in the sintering precursor can be, for example, 15 mass% or less, and particularly 10 mass% or less.

There is no particular limitation on the type of the organic solvent, and any organic solvent in which the metal microparticles can be dispersed to form a paste can be used. Examples of the organic solvent include monohydric alcohols, polyhydric alcohols, polyhydric alcohol alkyl ethers, polyhydric alcohol aryl ethers, polyethers, esters, nitrogen-containing heterocyclic compounds, amides, amines, terpene alcohols, ketones, saturated hydrocarbons, and the like. These organic solvents may be used alone or in a combination of two or more.

Examples of the monohydric alcohol include 1-propanol, 1-butanol, 1-pentanol, 1-hexanol, cyclohexanol, 1-heptanol, 1-octanol, 1-nonanol, 1-decanol, glycidol, benzyl alcohol, methylcyclohexanol, 2-methyl-1-butanol, 3-methyl-2-butanol, 4-methyl-2-pentanol, 2-propanol, 2-ethylbutanol, 2-ethylhexanol, 2-octanol, 2-methoxyethanol, 2-ethoxyethanol, 2-n-butoxyethanol, 2-phenoxyethanol, and the like.

Examples of the polyhydric alcohol include ethylene glycol, propylene glycol, 1,3-propanediol, 1,4-butanediol, 1,5-pentanediol, diethylene glycol, dipropylene glycol, triethylene glycol, tetraethylene glycol, hexylene glycol, and the like.

Examples of the polyhydric alcohol alkyl ether include ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, triethylene glycol monomethyl ether, triethylene glycol monoethyl ether, propylene glycol monobutyl ether, and the like.

Examples of the polyhydric alcohol aryl ether include ethylene glycol monophenyl ether and the like. Examples of the polyether include polyethylene glycol, polypropylene glycol, and the like. Examples of the ester include ethyl cellosolve acetate, butyl cellosolve acetate, γ-butyrolactone, and the like. Examples of the nitrogen-containing heterocyclic compounds include N-methylpyrrolidone, 1,3-dimethyl-2-imidazolidinone, and the like. Examples of the amide include formamide, N-methylformamide, N,N-dimethylformamide, and the like. Examples of the amine include monoethanolamine, diethanolamine, triethanolamine, tripropylamine, tributylamine, and the like. Examples of the terpene alcohol include isobornyl cyclohexanol, terpineol, and the like. Examples of the ketone include methyl ethyl ketone and the like. Examples of the saturated hydrocarbons include heptane, octane, nonane, decane, undecane, dodecane, tridecane, tetradecane, pentadecane, hexadecane, and the like.

On the other hand, with respect to a sintering precursor constituted by a sheet in which metal microparticles are dispersed in a resin, examples of the resin include thermoplastic resins, including: various polyolefin resins, such as polyethylene, polypropylene, polymethylpentene, and copolymers thereof; various polyamide resins, such as nylon 6, nylon 66, nylon 12, nylon 11, meta-xylylene adipamide (mXD6), hexamethylene terephthalamide (6T), and copolymers thereof; various polyester resins, such as polyethylene terephthalate (PET), polybutylene terephthalate (PBT), polyethylene-2,6-napthalate (PEN), polymethylene terephthalate (PMT), polypropylene terephthalate (PPT), polyethylene-p-oxybenzoate (PEOB), poly-1,4-cyclohexylenedimethylene terephthalate (PCT), and polyesters obtained by copolymerizing, for example, diol components such as diethylene glycol, neopentyl glycol, and polyalkylene glycol, dicarboxylic acid components such as adipic acid, sebatic acid, phthalic acid, isophthalic acid, and 2,6-naphthalenedicarboxylic acid, and the like as copolymerization components; as well as acrylic resins; methacrylic resins; polyacetal (POM) resins; polyphenylene sulfide (PPS) resins; polycarbonate resins; and chlorine-containing resins such as polyvinyl chloride (PVC) and polyvinylidene chloride (PVdC). Additionally, thermosetting resins, such as phenolic resins, epoxy resins, urea resins, melamine resins, and silicone resins, may also be used.

In the present invention, a bonded structure is produced by temporarily fixing the first bonding target material and the second bonding target material to each other with the temporary fixing composition disposed therebetween and bonding the temporarily fixed two bonding target materials to each other. It is preferable that components of the temporary fixing composition are selected in relation to the type of the organic solvent or the resin contained in the paste or the sheet, of the structure, used to form the sintering precursor and the type of the surface treatment agent attached to the surfaces of the metal microparticles contained in the paste or the resin.

The temporary fixing composition contains a first organic component that is solid at 25°C and has a 95% mass loss temperature in nitrogen of 300°C or lower, preferably 280°C or lower. The first organic component being solid at 25°C enables the temporary fixing composition to solidify after application. In addition, containing this first organic component, the temporary fixing composition can be applied, can quickly solidify after application and still have tackiness, and can be fired without leaving any residue. Note that, the term "apply" means to add the temporary fixing composition dropwise onto a material or to attach the temporary fixing composition to a target object or a target portion using a method such as dispensing, pin transferring, inkjet printing, or screen printing. The term "solid" means a substance that is rigid with no or very little deformation or volume change, does not flow to conform to the shape of a container, and does not diffuse to occupy the entire container. Examples include stone-like, rock-like, wax-like, and wax-like substances.

The first organic component is contained in a proportion of 42 mass% or more, preferably 55 mass% or more, and more preferably 60 mass% or more, within 100 mass% of the temporary fixing composition. By containing the first organic component in a proportion of 42 mass% or more within 100 mass% of the temporary fixing composition, the temporary fixing composition can solidify within a short period of time, for example, 240 seconds, after application in an atmosphere at 25°C. On the other hand, the first organic component is contained in a proportion of preferably 95 mass% or less, and more preferably 85 mass% or less, within 100 mass% of the temporary fixing composition. If the content of the first organic component is more than 95 mass% within 100 mass% of the temporary fixing composition, the temporary fixing composition may have reduced fluidity during application and cause, for example, nozzle clogging, resulting in failure of application.

Due to the first organic component contained in the temporary fixing composition, the solidification time can be shortened, specifically to 240 seconds or less, preferably 40 seconds or less, and more preferably 5 seconds or less. Therefore, the permeation of the composition into the structure, that is, the sintering precursor, over time can be suppressed, and even when the process time for bonding the first bonding target material and the second bonding target material to each other is long, tackiness to these bonding target materials can be ensured.

Note that the 95% mass loss temperature mentioned above refers to a 95% mass loss temperature as determined by increasing the temperature of a sample from 25°C to 40°C at a temperature increase rate of 2°C/min in a nitrogen stream, maintaining the temperature for 15 minutes, and then performing thermogravimetric-differential thermal analysis under the conditions at a temperature increase rate of 10°C/min in a nitrogen atmosphere (e.g., in a nitrogen stream) with a sample mass of 30 mg.

Examples of the first organic component include monohydric alcohols, polyhydric alcohols, polyhydric alcohol alkyl ethers, polyhydric alcohol aryl ethers, esters, heterocyclic compounds, amides, amines, saturated hydrocarbons, cyclic terpene alcohols and their derivatives, ketones, and carboxylic acids. These organic components may be used alone or in a combination of two or more. Among these organic components, saturated aliphatic monohydric alcohols, saturated aliphatic polyhydric alcohols, saturated fatty acid esters, cyclic terpene alcohol derivatives, oxygen-containing heterocyclic compounds, and saturated aliphatic monocarboxylic acids are preferable. Desirably, among these, those having 6 to 21 carbon atoms are preferable. Among these, particularly preferably, myristyl alcohol, palmityl alcohol, stearyl alcohol, 1,6-hexanediol, 2,2,4-trimethyl-1,3-pentanediol, trimethylolpropane, methyl stearate, borneol, 2,4,6-triisopropyl-1,3,5-trioxane, capric acid, lauric acid, myristic acid, palmitic acid, and the like are favorably used. These compounds may be used alone or in a combination of two or more.

It is preferable that the temporary fixing composition contains, in addition to the first organic component, a second organic component of a type different from that of the first organic component. The second organic component contained in the temporary fixing composition is a substance that is unlikely to deteriorate the first bonding target material and the second bonding target material when these bonding target materials are temporarily fixed to each other and that is easily volatilizable while the two bonding target materials are in the temporarily fixed state.

It is desirable that the second organic component is liquid at 25°C and has a 95% mass loss temperature in nitrogen of 300°C or lower, preferably 280°C or lower. The use of this second organic component in combination with the first organic component enables the temporary fixing composition to have fluidity during application while maintaining its tackiness and to be fired with good work efficiency without leaving any residue. Note that the 95% mass loss temperature is determined using the same procedure as that of the first organic component.

When the second organic component is contained in a proportion of 5 mass% or more, and preferably 15 mass% or more, within 100 mass% of the temporary fixing composition, the fluidity during application can be ensured. On the other hand, it is desirable that the second organic component is contained in a proportion of 58 mass% or less, preferably 45 mass% or less, and more preferably 40 mass% or less, within 100 mass% of the temporary fixing composition. When the content of the second organic component is 58 mass% or less within 100 mass% of the temporary fixing composition, the solidification time after application is shortened and the tackiness can be ensured.

Preferably, the second organic component is selected such that, when used in combination with the first organic component, the solidification time of the temporary fixing composition is shortened, specifically to 240 seconds or less, preferably 40 seconds or less, and more preferably 5 seconds or less. Thus, the solidification time of the temporary fixing composition can be shortened as described above. Therefore, the permeation of the composition into the structure, that is, the sintering precursor, over time can be suppressed, and even when the process time for bonding the first bonding target material and the second bonding target material to each other is long, tackiness to these bonding target materials can be ensured.

As the second organic component, any organic component that does not change the condition of the sintering precursor and can ensure fluidity during application, as described above, can be used. Examples of such organic component are similar to those listed above as examples of the organic solvent and include monohydric alcohols, polyhydric alcohols, polyhydric alcohol alkyl ethers, polyhydric alcohol aryl ethers, esters, heterocyclic compounds, amides, amines, saturated hydrocarbons, cyclic terpene alcohols and their derivatives, ketones, and carboxylic acids. These organic components may be used alone or in a combination of two or more. Among these organic components, saturated aliphatic polyhydric alcohols, unsaturated aliphatic monohydric alcohols, unsaturated fatty acid esters, tertiary amines, cyclic terpene alcohol derivatives, unsaturated aliphatic monocarboxylic acids, and saturated aliphatic hydrocarbons are preferable. Desirably, among these, those having 3 to 21 carbon atoms are preferable. Among these, particularly preferably, glycerol, 1,2,4-butanetriol, oleyl alcohol, methyl oleate, triethanolamine, 4-(1'-acetoxy-1'-methylethyl)-cyclohexanol acetate, isobornyl cyclohexanol, oleic acid, normal decane, and the like are favorably used. These compounds may be used alone or in a combination of two or more.

Note that the wording "does not change the condition of the sintering precursor" above means that, when 1 µL of the organic component is added dropwise onto the sintering precursor and dried under the conditions at 110°C or lower, no change is confirmed in the sintering precursor before and after the addition of the organic component when observed under a microscope at a magnification of 140x. The meaning of the wording "no change is confirmed" here involves not only a situation in which no change is observed in the sintering precursor before and after the addition of the organic component, but also a situation in which no trace of the addition of the organic component can be seen in an ultrasonic flaw detection image after bonding.

Preferred combinations of the first organic component and the second organic component include, for example, the following:
- A combination of a C8-C21 saturated aliphatic monocarboxylic acid as the first organic component and a C8-C21 saturated aliphatic hydrocarbon as the second organic component;
- A combination of a C8-C21 saturated aliphatic monocarboxylic acid as the first organic component and a C8-C21 cyclic terpene alcohol derivative as the second organic component;
- A combination of a C8-C21 saturated fatty acid ester as the first organic component and a C8-C21 cyclic terpene alcohol derivative as the second organic component;
- A combination of a C8-C21 saturated aliphatic monocarboxylic acid as the first organic component and a C8-C21 unsaturated aliphatic monohydric alcohol as the second organic component;
- A combination of a C8-C21 saturated aliphatic monocarboxylic acid as the first organic component and a C8-C21 unsaturated aliphatic monocarboxylic acid as the second organic component;
- A combination of a C8-C21 saturated aliphatic monohydric alcohol as the first organic component and a C8-C21 cyclic terpene alcohol derivative as the second organic component;
- A combination of a C8-C21 saturated aliphatic monohydric alcohol as the first organic component and a C8-C21 saturated aliphatic hydrocarbon as the second organic component;
- A combination of a C8-C21 saturated aliphatic monohydric alcohol as the first organic component and a C8-C21 unsaturated aliphatic monohydric alcohol as the second organic component; and
- A combination of a C8-C21 saturated aliphatic monohydric alcohol as the first organic component and a C8-C21 unsaturated aliphatic monocarboxylic acid as the second organic component.

Preferably, the following combinations are preferred for their ability to achieve tackiness and short solidification time:
- A combination of a C8-C21 saturated aliphatic monocarboxylic acid as the first organic component and a C8-C21 saturated aliphatic hydrocarbon as the second organic component;
- A combination of a C8-C21 saturated aliphatic monocarboxylic acid as the first organic component and a C8-C21 cyclic terpene alcohol derivative as the second organic component;
- A combination of a C8-C21 saturated fatty acid ester as the first organic component and a C8-C21 cyclic terpene alcohol derivative as the second organic component;
- A combination of a C8-C21 saturated aliphatic monocarboxylic acid as the first organic component and a C8-C21 unsaturated aliphatic monohydric alcohol as the second organic component;
- A combination of a C8-C21 saturated aliphatic monocarboxylic acid as the first organic component and a C8-C21 unsaturated aliphatic monocarboxylic acid as the second organic component; and
- A combination of a C8-C21 saturated aliphatic monohydric alcohol as the first organic component and a C8-C21 cyclic terpene alcohol derivative as the second organic component.

In addition to the first organic component and the second organic component that have been described above, the temporary fixing composition may also contain an additional component as long as the effects of the present invention are not inhibited.

It is preferable that the temporary fixing composition is substantially free of an organic polymer compound. Organic polymer compounds are generally non-volatile or hardly volatile. Therefore, the absence of an organic polymer compound in the temporary fixing composition allows, for example, the solidification time to be shortened, and thus, the permeation of the composition over time can be suppressed. As a result, even when the process time for bonding the first bonding target material and the second bonding target material to each other is relatively long, tackiness to the bonding target materials can be ensured. For this reason, it is preferable that the temporary fixing composition is substantially free of an organic polymer compound. For the same reason, it is also preferable that the temporary fixing composition is substantially free of an inorganic compound. The wording "substantially free of an organic polymer compound" means that an organic polymer compound is not intentionally contained in the temporary fixing composition, but inevitable contamination of the temporary fixing composition with an organic polymer compound is acceptable. The wording "substantially free of an inorganic compound" also has the same meaning.

Examples of the organic polymer compound above include: polyolefins such as polyethylene, polypropylene, and ethylene-α-olefin copolymers; polyesters such as polyethylene terephthalate and polybutylene terephthalate; vinyl polymers such as polyvinyl chloride and polystyrene; (meth)acrylic acid-based polymers such as poly(meth)acrylic acid and polyalkyl (meth)acrylate; terpene-based polymers such as polyethylene glycol, terpene polymers, and terpene phenolic polymers; and polycarbonate and polyether sulfone.

The temporary fixing composition can be adjusted by mixing the first organic component and the second organic component under heating to 30°C or higher and 70°C or lower. Alternatively, the temporary fixing composition can also be adjusted by mixing the first organic component and the second organic component and then heating the mixture to 30°C or higher and 70°C or lower.

Next, a method of use of the temporary fixing composition of the present invention will be described.

Figs. 1(a) to 1(d) schematically illustrate a process of bonding a first bonding target material and a second bonding target material to each other using the temporary fixing composition. First, as illustrated in Fig. 1(a), a paste containing metal microparticles and an organic solvent is applied onto a substrate 10 to form a coating film thereon, the organic solvent is then removed from the coating film, and thus, a sintering precursor, which is a dried product of the paste, or in other words, a second bonding target material 11 is formed. Alternatively, a sheet in which metal microparticles are dispersed in a resin is placed on the substrate 10 to form a sintering precursor, or in other words, a second bonding target material 11.

Fig. 1(a) illustrates a state in which a sintering precursor serving as the second bonding target material 11 is formed on the surface of a single substrate 10. The substrate 10 may be made of, for example, a metal such as copper, silver, nickel, gold, or aluminum or a ceramic such as alumina, silicon carbide, silicon nitride, or aluminum nitride. Moreover, metal plating, or a metal pattern, of copper, silver, nickel, gold, aluminum, or the like may also be formed on one side or both sides of the metal or the ceramic.

Subsequently, as illustrated in Fig. 1(b), a temporary fixing composition 12 is applied to the surface of the second bonding target material 11. Preferably, the temperature of the temporary fixing composition during application is between 30°C and 70°C. Preferably, the second bonding target material 11, to which the temporary fixing composition is applied, is not preheated, heated, or subjected to any similar treatment and is at a temperature between 20°C and 25°C. In addition, the room temperature of a room where this step is performed is preferably between 20°C and 25°C. The temporary fixing composition 12 may be provided on only a portion of the second bonding target material 11 (e.g., corners of the sintering precursor 11) as illustrated in Fig. 1(b), or may be provided over the entire region of the second bonding target material 11. To provide the temporary fixing composition 12, a known method, such as dispensing, pin transferring, inkjet printing, or screen printing, for example, can be employed.

Subsequently, as illustrated in Fig. 1(c), a first bonding target material 13 is superposed on the second bonding target material 11. A surface of the first bonding target material 13 that faces the second bonding target material 11 is made of a metal. The temporary fixing composition 12 is disposed between the two bonding target materials 11 and 13 as a result of the superposition. Since the temporary fixing composition 12 preferably does not contain a component that changes the condition of the sintering precursor, which is the second bonding target material 11, the shape of the second bonding target material 11 is stably maintained. Moreover, the temporary fixing composition 12 preferably contains a highly viscous component, and therefore, the temporarily fixed state of the two bonding target materials 11 and 13 is stably maintained.

Next, the temporarily fixed bonding target materials 11 and 13 are heated. Due to the heating, the metal microparticles contained in the second bonding target material 11, or the sintering precursor, are sintered, and the two bonding target materials 11 and 13 are thus bonded to each other. Fig. 1(d) illustrates this step. Since heating is usually performed in a furnace (not shown), the temporarily fixed bonding target materials 11 and 13 shown in Fig. 1(c) are transported from a stage shown in Fig. 1(c) to a heating stage by a transporting means (not shown). Since the bonding target materials 11 and 13 are reliably and quickly fixed to each other by the temporary fixing composition 12, the bonding target materials 11 and 13 can be effectively prevented from becoming misaligned during transportation. As a result, in the furnace, the bonding target materials 11 and 13 are reliably bonded to each other at an original planned bonding position.

When heating the bonding target materials 11 and 13, pressure may be applied thereto using a pressure member 14. In particular, in the case where the first bonding target material 13 is a semiconductor device, it is necessary to increase the reliability of bonding between the first bonding target material 13 and the second bonding target material 11, and therefore, there are cases where the pressure member 14 is used in order to form a dense sintered structure. If the pressure member 14 is used, the bonding target materials 11 and 13 in the temporarily fixed state are likely to become misaligned. However, when the bonding target materials 11 and 13 are temporarily fixed to each other using the temporary fixing composition 12 of the present invention, the bonding target materials 11 and 13 are unlikely to become misaligned even when pressure is applied to the bonding target materials 11 and 13 using the pressure member 14.

In order to reliably bond the bonding target materials 11 and 13 to each other, the pressure applied by the pressure member 14 during heating is preferably 0.01 MPa or more and 40 MPa or less. The heating temperature is preferably 200°C or higher and 300°C or lower. Heating at this temperature enables the metal microparticles in the sintering precursor, which is the second bonding target material 11, to be reliably sintered and the temporary fixing composition 12 to be removed by heat. With regard to the sintering atmosphere, any of an oxygen-containing atmosphere such as atmospheric air, an inert atmosphere such as nitrogen, and a hydrogen-containing atmosphere can be used. As a result of this heating step, the substrate 10 and the bonding target materials 11 and 13 are integrally bonded together.

The present disclosure also encompasses the following inventions.
[1] A temporary fixing composition comprising:
   a first organic component in a proportion of 42 mass% or more and 95 mass% or less, the first organic component being solid at 25°C and having a 95% mass loss temperature in nitrogen of 300°C or lower,
   wherein the temporary fixing composition is used to temporarily fix a first bonding target material and a second bonding target material to each other before the first bonding target material and the second bonding target material are bonded to each other.
[2] The temporary fixing composition as set forth in clause [1], comprising a second organic component in a proportion of 5 mass% or more and 58 mass% or less, the second organic component being liquid at 25°C and having a 95% mass loss temperature in nitrogen of 300°C or lower.
[3] The temporary fixing composition as set forth in clause [1] or [2], which has a solidification time after application of 240 seconds or less.
[4] The temporary fixing composition as set forth in any one of clauses [1] to [3], which is substantially free of an organic polymer compound.
[5] A method for producing a bonded structure, comprising:
   temporarily fixing a first bonding target material and a second bonding target material to each other with a temporary fixing composition disposed between the first bonding target material and the second bonding target material; and
   firing the first bonding target material and the second bonding target material which are temporarily fixed to bond the first bonding target material and the second bonding target material to each other,
   wherein the temporary fixing composition comprises a first organic component in a proportion of 42 mass% or more and 95 mass% or less, the first organic component being solid at 25°C and having a 95% mass loss temperature in nitrogen of 300°C or lower.
[6] The method as set forth in clause [5], wherein the temporary fixing composition comprises second organic component in a proportion of 5 mass% or more and 58 mass% or less, the second organic component being liquid at 25°C and having a 95% mass loss temperature in nitrogen of 300°C or lower.
[7] The method as set forth in clause [5] or [6], wherein at least one of the first bonding target material and the second bonding target material comprises a sintering precursor of a structure containing metal microparticles.
[8] Use of a composition for temporarily fixing a first bonding target material and a second bonding target material to each other before the first bonding target material and the second bonding target material are bonded to each other,
   the composition comprising:
   a first organic component in a proportion of 42 mass% or more and 95 mass% or less, the first organic component being solid at 25°C and having a 95% mass loss temperature in nitrogen of 300°C or lower.
[9] The use as set forth in clause [8] for temporarily fixing the first bonding target material and the second bonding target material to each other before the first and second bonding target materials are bonded to each other, wherein the composition comprises a second organic component in a proportion of 5 mass% or more and 58 % or less, the second organic component being liquid at 25°C and having a 95% mass loss temperature in nitrogen of 300°C or lower.

### Examples

Hereinafter, the present invention will be described in further detail based on examples. However, the scope of the present invention is not limited to the examples given below. Unless otherwise stated, the percent sign "%" used herein means "mass%".

### Examples 1 to 5 and Comparative Examples 1 and 2

### (1) Preparation of Temporary Fixing Composition

Lauric acid (solid at 25°C, 95% loss temperature: 256°C) was used as the first organic component. Normal decane (liquid at 25°C, 95% loss temperature: 144°C) was used as the second organic component. The first and second organic components, both at 50°C, were mixed to prepare a temporary fixing composition. The percentages of the first organic component and the second organic component in the temporary fixing composition were as shown in Table 1. The temporary fixing composition was free of an organic polymer compound and an inorganic compound.

### (2) Preparation of Bonding Paste

Two types of copper particles (spherical particles with D_{SEM50} = 0.14 µm and flake-shaped particles with D_{SEM50} = 4.7 µm) synthesized using a wet method, hexylene glycol and polyethylene glycol (number average molecular weight: 300) serving as organic solvents, and other adjusting agents such as a solid reducing agent were mixed to prepare a bonding paste. Bis(2-hydroxyethyl)iminotris(hydroxymethyl)methane (hereinafter also referred to as "BIS-TRIS") was used as the solid reducing agent.

In the bonding paste, the proportion of the copper particles was 74%, the proportion of hexylene glycol was 23.4%, and the proportion of polyethylene glycol was 0.74%. The spherical particles accounted for 70% of the copper particles, and the flake-shaped particles accounted for 30% of the copper particles. The proportion of BIS-TRIS used as the solid reducing agent was 1.85%.

### (3) Formation of Second Bonding Target Material Constituted by Sintering Precursor

The bonding paste was applied, through screen printing, onto a substrate made of a copper plate (20 mm × 20 mm, thickness: 0.5 mm) to form a rectangular coating film with a size of 0.6 cm × 0.6 cm and a thickness of 100 µm. The coating film was dried at 110°C in an atmosphere of air for 20 minutes to remove the organic solvents, and thus, a second bonding target material constituted by a sintering precursor, which was the dried product, was formed.

### (4) Dropwise Addition or Application of Temporary Fixing Composition and Superposition of First Bonding Target Material

The temporary fixing composition was added dropwise as soon as the temperature of the sintering precursor formed in (3) became equivalent to room temperature (22°C). An Ag-plated alumina chip (0.5 cm × 0.5 cm, thickness: 0.5 mm, mass: 50 mg) serving as a first bonding target material was provided as a model member of a semiconductor device. A compact mounter (SMT-64RH manufactured by Okuhara Electric Co., Ltd.) was used to superpose the alumina chip and the sintering precursor formed in (3) one on top of the other. The temporary fixing composition prepared in (1) was filled into a 10-ml syringe with a plastic needle (both manufactured by Musashi Engineering, Inc.), and the syringe was attached to a temperature control unit included in the mounter. As the temperature control unit, a fan-type Peltier temperature control unit, PELTIER MASTER (manufactured by Musashi Engineering, Inc.) was used. The temperature control unit was set to 50°C and allowed to stand for 30 minutes until the temperature of the temporary fixing composition stabilized. Then, the ejection pressure, ejection time, and back pressure were adjusted to adjust the application amount to 0.04 mg per droplet. One droplet of the temporary fixing composition was applied to each corner of the sintering precursor in accordance with the mounter's program. Subsequently, the Ag-plated surface of the alumina chip was superposed on the sintering precursor, and a load of 0.8 MPa was applied thereto for 2 seconds. The superposing position of the alumina chip was set so that the intersection point of the diagonals of the alumina chip aligned with that of the sintering precursor and, furthermore, each side of the alumina chip was parallel to the corresponding side of the sintering precursor portion. The application position of the temporary fixing composition was set so that each corner of the alumina chip was located at the center of the corresponding fraction of the composition that had been applied. These alignments were performed by image processing in the mounter's program. Note that these operations, including the application, were performed at room temperature (22°C), and the second bonding target material was not preheated or subjected to any similar treatment.

### Examples 6 to 10

The same production procedure as in Examples 1 to 5 was followed up to (4) Superposition of First Bonding Target Material, except that, as shown in Table 2, instead of normal decane, 4-(1'-acetoxy-1'-methylethyl)-cyclohexanol acetate (liquid at 25°C, 95% loss temperature: 236°C) was used as the second organic component.

### Example 11

The same production procedure as in Examples 6 to 10 was followed up to (4) Superposition of First Bonding Target Material, except that, as shown in Table 3, instead of lauric acid, methyl stearate (solid at 25°C, 95% loss temperature: 298°C) was used as the first organic component.

### Example 12

The same production procedure as in Examples 1 to 5 was followed up to (4) Superposition of First Bonding Target Material, except that, as shown in Table 3, instead of normal decane, oleyl alcohol (liquid at 25°C, 95% loss temperature: 295°C) was used as the second organic component.

### Example 13

The same production procedure as in Examples 1 to 5 was followed up to (4) Superposition of First Bonding Target Material, except that, as shown in Table 3, instead of normal decane, oleic acid (liquid at 25°C, 95% loss temperature: 321°C) was used as the second organic component.

### Example 14

The same production procedure as in Examples 6 to 10 was followed up to (4) Superposition of First Bonding Target Material, except that, as shown in Table 3, instead of lauric acid, palmityl alcohol (solid at 25°C, 95% loss temperature: 270°C) was used as the first organic component.

### Comparative Example 3

The same production procedure as in Examples 6 to 10 was followed up to (4) Superposition of First Bonding Target Material, except that, as shown in Table 4, instead of lauric acid, stearic acid (solid at 25°C, 95% loss temperature: 314°C) was used as the first organic component.

### Comparative Example 4

The same production procedure as in Examples 6 to 10 was followed up to (4) Superposition of First Bonding Target Material, except that, as shown in Table 4, instead of lauric acid, lauryl alcohol (liquid at 25°C, 95% loss temperature: 229°C) was used as the first organic component.

### <95% Mass Loss Temperatures of First and Second Organic Components>

For each of the first organic component and the second organic component, the 95% mass loss temperature was derived from the 95% loss temperature as determined by increasing the temperature of a sample from 25°C to 40°C at a temperature increase rate of 2°C/min in a nitrogen stream, maintaining this temperature for 15 minutes, and then performing thermogravimetric-differential thermal analysis under the conditions at a temperature increase rate of 10°C/min in a nitrogen stream with a sample mass of 30 mg using an apparatus for simultaneous differential thermal analysis and thermogravimetric analysis, TG-DTA2000SA, manufactured by Bruker AXS.

### <Evaluation of Solidification Time>

The solidification time was defined as the time from the dropwise addition or application of the temporary fixing composition at 50°C to the second bonding target material, constituted by the sintering precursor, at a temperature equivalent to room temperature (22°C), until the solidification of the temporary fixing composition. Solidification was defined as the time when it was visually confirmed that the temporary fixing composition became cloudy due to viscosity increase after the dropwise addition or application. After solidification, there was no permeation into the sintering precursor, and the size of the fractions of the temporary fixing composition added dropwise or applied did not change over time. In Comparative Example 1, since the content of the first organic component was 96 mass%, the fluidity during application could not be ensured, resulting in the failure of application. Consequently, the solidification time could not be evaluated, and no data was recorded (indicated as "-"). In Comparative Example 3, since the first organic component used had a 95% mass loss temperature in nitrogen of 314°C, the fluidity during application could not be ensured, resulting in the failure of application. Consequently, the solidification time could not be evaluated, and no data was recorded (indicated as "-"). In Comparative Examples 2 and 4, although the temporary fixing composition could be applied, no solidification occurred (indicated as "×").

### <Evaluation of Tackiness>

After the alumina chip was superposed, the resulting product was allowed to stand for 24 hours. Subsequently, the resulting product was placed upright so that surfaces to be bonded to each other of the copper plate and the alumina chip extended in the vertical direction, allowed to stand for 5 seconds, and then returned to horizontal. This operation was performed a total of 6 times. A case where the alumina chip did not come off the copper plate during all six cycles of operation was rated as "A", and a case where the alumina chip came off the copper plate during any cycle of operation was rated as "B". In Comparative Examples 1 and 3, due to the failure of application, the tackiness could not be evaluated, and no data was recorded (indicated as "-").

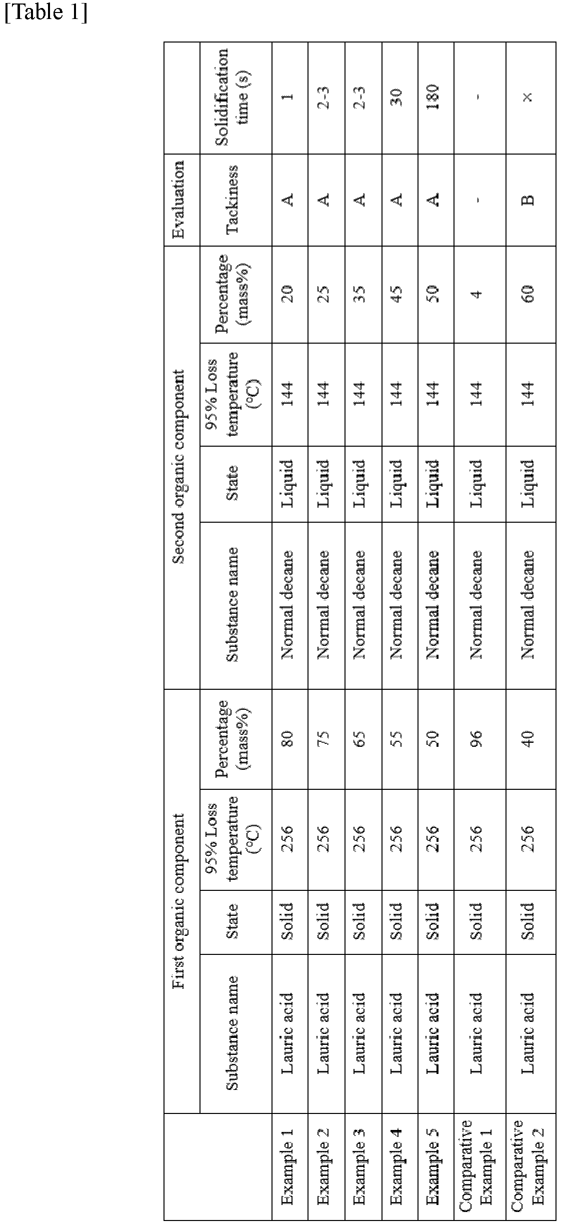

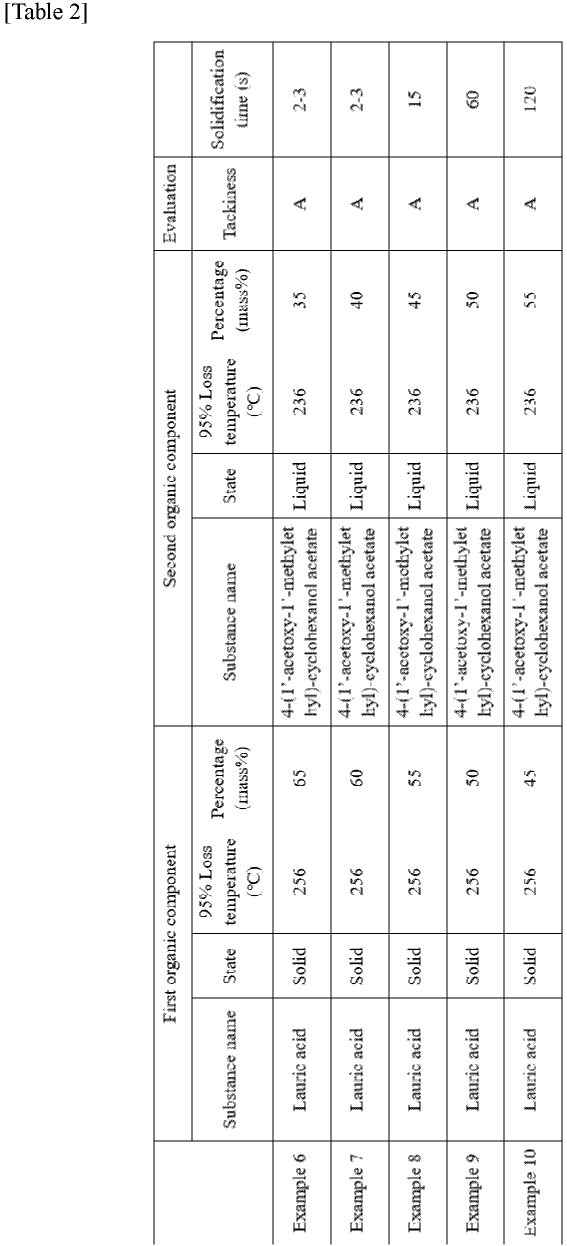

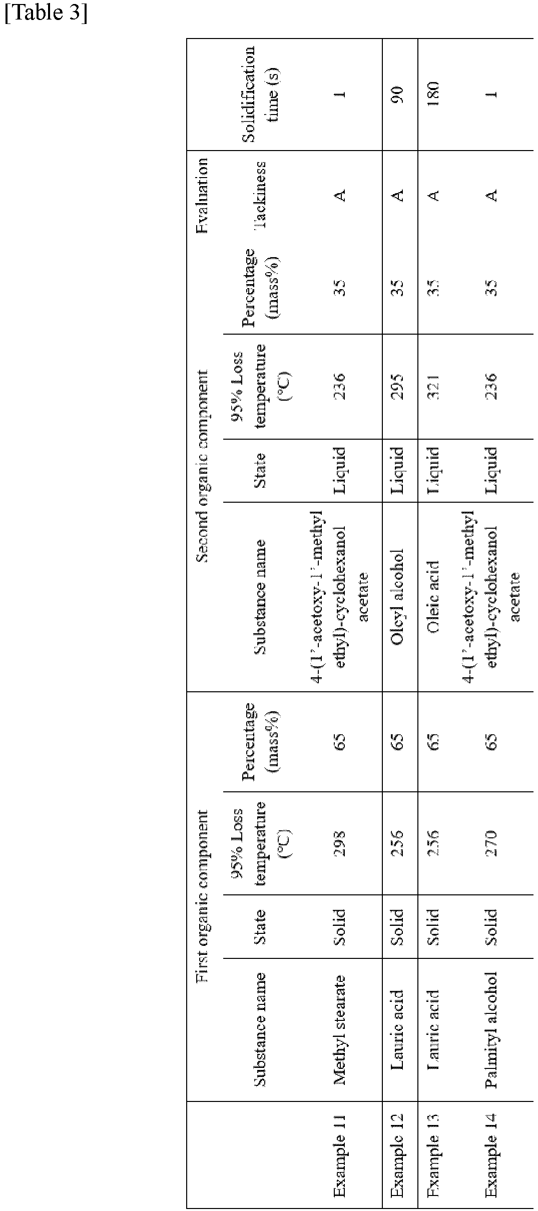

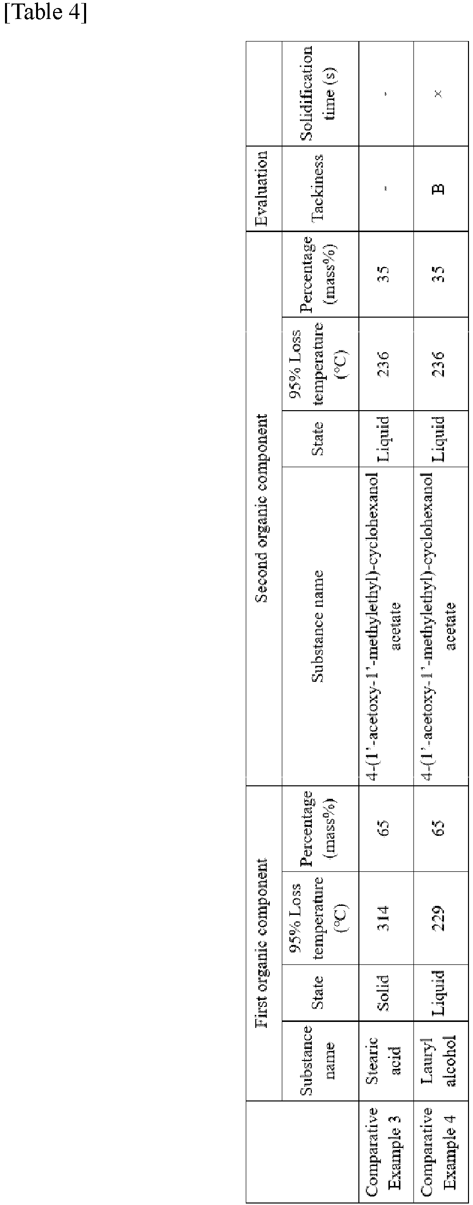

As is clear from the tables, it can be seen that the examples exhibited a short solidification time and excellent tackiness.

### Industrial Applicability

According to the present invention, it is possible to provide a temporary fixing composition that solidifies in a short time. Therefore, the permeation of the temporary fixing composition into a bonding material over time can be suppressed, and even when the process time for bonding two bonding target materials to each other is long, tackiness to these bonding target materials can be ensured.

## Claims

1. A temporary fixing composition comprising:
a first organic component in a proportion of 42 mass% or more and 95 mass% or less, the first organic component being solid at 25°C and having a 95% mass loss temperature in nitrogen of 300°C or lower,
wherein the temporary fixing composition is used to temporarily fix a first bonding target material and a second bonding target material to each other before the first bonding target material and the second bonding target material are bonded to each other.

2. The temporary fixing composition according to claim 1, comprising a second organic component in a proportion of 5 mass% or more and 58 mass% or less, the second organic component being liquid at 25°C and having a 95% mass loss temperature in nitrogen of 300°C or lower.

3. The temporary fixing composition according to claim 1 or 2, which has a solidification time after application of 240 seconds or less.

4. The temporary fixing composition according to claim 1 or 2, which is substantially free of an organic polymer compound.

5. A method for producing a bonded structure, comprising:
temporarily fixing a first bonding target material and a second bonding target material to each other with a temporary fixing composition disposed between the first bonding target material and the second bonding target material; and
firing the first bonding target material and the second bonding target material which are temporarily fixed to bond the first bonding target material and the second bonding target material to each other,
wherein the temporary fixing composition comprises a first organic component in a proportion of 42 mass% or more and 95 mass% or less, the first organic component being solid at 25°C and having a 95% mass loss temperature in nitrogen of 300°C or lower.

6. The method according to claim 5, wherein the temporary fixing composition comprises second organic component in a proportion of 5 mass% or more and 58 mass% or less, the second organic component being liquid at 25°C and having a 95% mass loss temperature in nitrogen of 300°C or lower.

7. The method according to claim 5 or 6, wherein at least one of the first bonding target material and the second bonding target material comprises a sintering precursor of a structure containing metal microparticles.

8. Use of a composition for temporarily fixing a first bonding target material and a second bonding target material to each other before the first bonding target material and the second bonding target material are bonded to each other,
the composition comprising:
a first organic component in a proportion of 42 mass% or more and 95 mass% or less, the first organic component being solid at 25°C and having a 95% mass loss temperature in nitrogen of 300°C or lower.

9. The use according to claim 8 for temporarily fixing the first bonding target material and the second bonding target material to each other before the first bonding target material and the second bonding target material are bonded to each other, wherein the composition comprises a second organic component in a proportion of 5 mass% or more and 58 % or less, the second organic component being liquid at 25°C and having a 95% mass loss temperature in nitrogen of 300°C or lower.
